# FASCICULE DE BREVET EUROPEEN

(11) **EP 0 948 663 B1**
(45) Date de publication et mention de la délivrance du brevet: **10.08.2005**
(21) Numéro de dépôt: 97948944.0
(22) Date de dépôt: 27.11.1997
(51) Int. Cl.: C23C 14/34, C22C 21/00, C22C 21/12

(54) **CIBLES DE PULVERISATION CATHODIQUE EN ALLIAGE D'ALUMINIUM**
SPUTTER TARGET AUS ALUMINIUM-LEGIERUNG
CATHODE PULVERISATION TARGETS IN ALUMINIUM ALLOY

(30) Priorité: 04.12.1996 FR 9615116
(43) Date de publication de la demande: 13.10.1999
(73) Titulaire: ALUMINIUM PECHINEY, 92400 Courbevoie (FR)
(72) Inventeur: LEROY, Michel, F-38120 Saint Egreve (FR); MULLER, Jean, F-09400 Tarascon-sur-Ariège (FR); CHENAL, Bruno, F-38960 Saint-Etienne-de-Crossey (FR)
(74) Mandataire: Pigasse, Daniel
(86) Numéro de dépôt international: PCT/FR1997/002142
(87) Numéro de publication internationale: WO 1998/024945

(56) Documents cités:
- EP-A- 0 442 752
- EP-A- 0 573 002
- JP-A- 4 009 466
- US-A- 5 032 468
- PATENT ABSTRACTS OF JAPAN vol. 008, no. 067 (C-216), 29 mars 1984 -& JP 58 221265 A (NIHON KEIKINZOKU KK), 22 décembre 1983,
- PATENT ABSTRACTS OF JAPAN vol. 096, no. 010, 31 octobre 1996 -& JP 08 144030 A (FURUKAWA ELECTRIC CO LTD:THE;TOYO ALUM KK)
- PATENT ABSTRACTS OF JAPAN vol. 012, no. 117 (C-487), 13 avril 1988 -& JP 62 240733 A (NIPPON MINING CO LTD), 21 octobre 1987, cité dans la demande
- PATENT ABSTRACTS OF JAPAN vol. 012, no. 110 (C-486), 8 avril 1988 -& JP 62 235451 A (NIPPON MINING CO LTD), 15 octobre 1987, cité dans la demande
- 1988, ALUMINIUM VERLAG , DÜSSELDORF Aluminium Taschenbuch, DIN 1712, Seite 1000
- 1965, SPRINGER-VERLAG , BERLIN, ALLEMAGNE D. Altenpohl, Aluminium und Aluminiumlegierungen, pages 519-521,603-631

## Description

### Domaine de l'invention

L'invention concerne les cibles de pulvérisation cathodique destinées à la métallisation de substrats divers. Elle concerne plus particulièrement les cibles destinées à la fabrication de circuits intégrés, notamment à la réalisation de circuits d'interconnexion, et le domaine de la métallisation des moniteurs à écran plat (Flat Panel Displays,ou FPD, en langue anglaise) de grandes dimensions.

L'invention concerne tout particulièrement les alliages d'aluminium utilisés dans la partie active des cibles de pulvérisation cathodiques.

Dans la présente demande, les teneurs en éléments et en impuretés sont exprimées en valeur pondérale.

### Etat de la technique et problèmes posés

L'industrie de l'électronique utilise abondamment des circuits d'interconnexion électriques à base d'aluminium ou d'alliages d'aluminium, notamment dans les circuits à très haut niveau d'intégration, telles que les mémoires dynamiques DRAM de capacité supérieure à 4 Mégabits, et dans les moniteurs à écran plat (FPD), tels que les écrans à cristaux liquides (Liquid Crystal Displays ou LCD en anglais), et en particulier ceux pilotés par transistors en film mince (Thin Film Transistor ou TFT en anglais).

Ces circuits d'interconnexion sont obtenus industriellement à l'aide de la technique bien connue de la pulvérisation cathodique, qui permet de déposer différents types de matériaux, réfractaires ou non, alliés ou non, conducteurs ou diélectriques, sur divers types de substrats qui peuvent être mis sous vide et qui supportent un léger échauffement. Les procédures connues comprennent généralement une série d'opérations de métallisation du substrat, de gravure et de passivation de la couche métallique. Lors de la métallisation, le substrat est généralement maintenu à une température, dite de métallisation (Tm), supérieure à 180°C, et le plus souvent de l'ordre de 200°C à 250°C, bien que la tendance actuelle soit à l'utilisation de températures de métallisation de l'ordre de 170°C à 200°C.

Dans les circuits à très haut niveau d'intégration, la couche métallique est typiquement d'une épaisseur de l'ordre de 0,5 µm à 1 µm, la gravure est très fine, à savoir typiquement de l'ordre de 0,25 à 0,5 µm, et les densités de courant sont très élevées, allant parfois jusqu'à plus de 10⁶ A/cm², en particulier lors des tests accélérés de vieillissement. Dans ces conditions, on observe une dégradation des circuits à l'usage par un phénomène d'électromigration qui entraîne la formation de trous et de protubérances. Afin de résoudre ce problème, il est bien connu de réaliser la métallisation à partir d'alliages d'aluminium à fortes teneurs, c'est-à-dire généralement supérieures à 2 500 ppm, en éléments d'addition choisis, tels que Cu. Ti, Si, Sc, Pd, et leurs combinaisons. Ces alliages présentent cependant l'inconvénient d'une gravure assez difficile, notamment du fait de la réactivité différente de l'aluminium et des éléments d'addition aux réactifs utilisés pour la gravure des circuits, et de l'élimination parfois difficile des produits issus des réactions chlimiques de gravure, en particulier pour les procédés de gravure à sec.

Il est également connu par les demandes japonaises JP 62.235451 à JP 62.235454 et JP 62.240733 à JP 62.240739 d'utiliser des alliages d'aluminium de haute pureté contenant des additions modérées, c'est-à-dire généralement moins de 200 ppm, de cuivre, de cobalt, de manganèse, de nickel, d'étain, d'indium, d'or ou d'argent associées à des additions de métaux réfractaires tels que titane, zirconium, hafnium, vanadium, niobium, tantale, chrome, molybdène ou tungstène en quantités comprises entre 20 et 7000 ppm et à une addition de bore, de carbone et/ou d'azote en quantités comprises entre 20 et 5000 ppm. Ces alliages complexes présentent l'inconvénient d'être difficiles à élaborer, et, en particulier, à couler sans ségrégations locales d'éléments intermétalliques, ce qui peut entraîner une hétérogénéité de composition des cibles.

Dans le cas des moniteurs à écran plat, cependant, la largeur des gravures est généralement supérieure ou égale 10 µm, et.il est envisagé d'utiliser des largeurs de l'ordre de 5 µm afin d'améliorer la définition des images. Les gravures de moniteurs à écran plat sont donc beaucoup moins fines que celles des circuits à très haut niveau d'intégration. Les densités de courant sont également nettement plus faibles. Dans ces conditions, la dégradation des circuits par électromigration est quasiment inexistante, de sorte que l'utilisation d'alliages à fortes teneurs en éléments d'addition ne se justifie plus. On utilise donc en général de l'aluminium très pur, non allié, qui présente les avantages importants de se graver beaucoup plus facilement que les alliages, de posséder une très haute conductivité électrique et de bien résister à la corrosion

Or, la tendance actuelle dans le domaine des moniteurs à écran plat, qui est en très fort développement, est à la production de moniteurs de grandes dimensions. Les développements en cours visent notamment les moniteurs de PC de 17" et 20" de diagonale, et les écrans plats de télévision murale de 40" de diagonale, c'est-à-dire des surfaces allant jusqu'à environ 0.5 m² Par ailleurs, pour des raisons de productivite et de rendement, ces moniteurs et écrans sont obtenus, soit directement, soit par découpe, à partir des mêmes substrats (également appelés "verres"). La tendance actuelle est par conséquent à une croissance rapide de la taille des substrats de verre. Les formats standards-actuels, qui sont d'environ 360 mm x 460 mm, seront bientôt portés à 550 mm x 650 mm, et il est envisagé de recourir à des substrats d'environ 800 mm x 1000 mm pour la production simultanée des écrans plats de 17", 20" et 40" de diagonale.

Ces tendances ont rendu prépondérant le problème qui consiste en l'apparition de trous et de protubérances (appelées "voids" et "hillocks" dans le vocable anglo-saxon) à la surface des films de métallisation lors des traitements thermiques inhérents aux procédés de fabrication des moniteurs et dont le caractère rédhibitoire croit rapidement avec la taille des moniteurs. C'est le cas en particulier des procédés de fabrication des moniteurs qui incluent la formation de couches d'oxyde thermique (Thermal Oxide Films en anglais) par échauffement à des températures supérieures à 300°C ou le dépôt de couches complémentaires par réaction chimique en phase vapeur (Chemical Vapor Deposition, ou CVD, en anglais). Les trous et protubérances produits par ces traitements thermiques peuvent provoquer des défauts d'interconnexion qui dégradent la qualité de fimage. Les critères de qualité de l'image étant sévères, il suffit de quelques défauts pour entraîner le rebut d'un moniteur complet en production.

L'origine de ce problème est encore mal comprise. Selon une des explications avancées (P.R. Besser et al.. Materials Research Society. Symposium Proceedings, Vol. 309, 1993, p. 181-186 et 287-292), et qui est généralement acceptée, l'apparition des protubérances et des trous est notamment attribuée à l'apparition de très fortes contraintes provoquées par la différence importante de coefficient de dilatation thermique entre le film d'aluminium et le substrat. Ces contraintes pourraient largement dépasser la limite élastique de l'aluminium. Lorsque le moniteur serait porté à une température supérieure à la température de métallisation, le film d'aluminium serait mis en compression et certains grains, plus plastiques, seraient extrudés hors du film sous la pression des grains adjacents. Lors du refroidissement, le film serait mis en tension et provoquerait l'apparition de trous pour relaxer les contraintes (phénomène appelé "stress-voiding" dans la littérature anglo-saxonne). Selon certains auteurs, l'apparition des protubérances serait liée à l'existence de zones à grains désorientés par rapport au reste du film lorsque celui-ci est à structure fortement structurée (D.B. Knorr, Materials Research Society, Symposium Proceedings. Vol. 309, 1993, p. 75-86). Enfin, d'autres auteurs associent la formation de protubérances à un phénomène de croissance anormale de certains grains qui proviendrait de l'existence de certains joints de grains d'orientation particulière et ayant une très grande mobilité (K. Rajan, Electrochemical Society Proceedings, Vol. 95-3, 1995, p. 81-93).

Afin de résoudre ce problème, tout particulièrement dans le domaine des circuits semi-conducteurs intégrés, il a été proposé d'utiliser des circuits d'interconnexion multicouche, c'est-à-dire formés de couches alternées miuces d'alliages d'aluminium et de métaux réfractaires. Par exemple, le brevet américain US 4 673 623 préconise l'utilisation d'une pluralité de couches alternées d'alliage d'aluminium (Al + 1 % Si) et de titane ou de tungstène. Selon la demande de brevet européen n° 681 328 de Xerox Corp., on limite de préférence l'épaisseur de chacune des couches alternées à une valeur faible et inférieure à une valeur critique d'apparition des protubérances. Le brevet US 5 171 642 de IBM Corp. propose l'utilisation de couches alternées d'un alliage d'aluminium, contenant de préférence 0,5 % de Cu, et d'un métal réfractaire, de préférence du titane, ayant réagi avec l'aluminium de manière à former des composés intermétalliques, tels que TiAl₃. Il a aussi été proposé par le brevet US 5 202 274 de former une couche d'oxyde d'aluminium sur le conducteur en alliage d'aluminium tel que Al-Si. Al Pd. Al-Ni, Al-Ge ou Al-W. Cependant, les circuits d'interconnexion multicouche, qui sont obtenus selon ces solutions et qui offrent une résistance satisfaisante à la formation des protubérances, présentent une résistance électrique élevée et, dans les meilleurs cas, supérieure à 3,3 µΩ.cm. Ces solutions ont aussi pour inconvénient de compliquer les procédés de fabrication, ce qui grève les coûts de fabrication de manière significative, voire rédhibitoire.

Il a aussi été proposé d'utiliser les mêmes alliages que ceux utilisés dans les circuits à très haut niveau d'intégration pour éliminer le problème de dégradation par électromigration, tels que Al + 0,5% Cu, Al + 0,1% Cu + 0.15% Ti, Al + 0,5% Cu + 1% Si. De même il a été proposé de recourir à des alliages spécifiques fortement chargés en éléments d'addition capables de limiter l'apparition des protubérances, tels que des alliages à 12 % de Ta, ou des alliages comportant de fortes teneurs combinées en Ti et en B, et donc riches en précipités intermétalliques TiB₂ (soit environ 500 ppm), ou encore des alliages à 10 % en poids de Nd.

Cependant, ces alliages chargés, c'est-à-dire à fortes teneurs en éléments réfractaires ou fortement chargés en éléments d'addition, présentent, lors de la fabrication des cibles, de très grandes difficultés d'élaboration et/ou de coulée, dans des conditions permettant d'en garantir la propreté, c'est-à-dire une faible teneur eu gaz et/ou en inclusions non métalliques, telles que des carbures, des nitrures et des oxydes, et l'homogénéité de composition tant à l'échelle macroscopique qu'à l'échelle microscopique, ce qui est essentiel pour éviter ultérieurement des défauts rédhibitoires de gravure, tels que le dépôt de particules inattaquables lors de la gravure dans le film d'alliage ou la formation d'un film chimiquement hétérogène.

En particulier, les alliages contenant des terres rares, telles que le néodyme, qui est très réactif, sont extrêmement difficiles à élaborer et à couler par coulée continue tout en garantissant simultanément l'absence d'inclusions réfractaires néfastes telles que des oxydes, des carbures,.... Ces inclusions, lors de l'utilisation de la cible, peuvent provoquer la formation de micro-arcs locaux, et par conséquent le dépôt de particules ou gouttelettes sur, et dans, le film de métallisation, ce qui entraîne par la suite d'importants défauts de gravure.

D'autre part, les alliages chargés rendent également la gravure assez difficile par la présence de précipités intermétalliques dont la présence est inévitable lorsque l'on recherche une résistivité modérée. Cette difficulté apparait tout particulièrement avec les alliages contenant du cuivre. En effet, les réactifs d'attaque convenant à la gravure de l'aluminium réagissent avec le cuivre présent dans l'alliage lors de l'attaque de gravure et produisent des composés chimiques, tels que des chlorures ou des fluorures, qui sont difficilement volatilisables ou difficilement solubles dans les solvants de nettoyage courants. De plus, le cuivre forme des précipités de Al₂Cu qui nuisent à la gravure lorsque leur taille est importante par rapport aux dimensions de la gravure.

Le critère de l'homogénéité du film prend aussi une importance d'autant plus grande que le substrat est de grandes dimensions, car les dimensions de la cible croissent généralement avec celles du substrat. En effet, l'homogénéité du film dépend de la finesse du grain, de l'homogénéité et de l'uniformité de la composition dans tout le volume actif de la cible, ce qui est plus difficile à réaliser dans les cibles de grandes dimensions lorsque les alliages sont chargés. Or, les alliages chargés en additions réfractaires, tels que les alliages contenant du Ta et du TiB₂, ont une température de fusion complète très élevée, ce qui pose des problèmes considérables lors de la coulée d'ébauches de grandes dimensions par le procédé classique de coulée continue, seul apte à assurer une répartition très homogène des éléments d'alliage, sans ségrégation locale dans la pièce coulée.

En outre, la résistivité électrique des alliages chargés est nettement plus élevée que celle de l'aluminium pur, même après un traitement thermique postérieur à la métallisation. En effet, la résistivité des alliages utilisés ou envisagés est généralement supérieure à 3 µΩ.cm, même après traitement thermique. Par conséquent, la consommation énergétique lors de l'utilisation des moniteurs est plus importante, ce qui conduit notamment à une diminution de l'autouomie des systèmes portables alimentés par batteries. Une augmentation de la résistivité entraîne aussi une augmentation des délais de réponse aux impulsions électriques pilotant les transistors de commande des pixels élémentaires, ce qui est particulièrement gênant pour les applications telles que les écrans plats vidéo qui nécessitent de grandes vitesses de renouvellement des images.

Enfin, ces alliages grèvent le plus souvent les coûts de fabrication de manière rédhibitoire.

La demanderesse a donc recherché des alliages d'aluminium qui permettent de réduire notablement l'apparition de protubérances et de trous lors des traitements thenniques, qui présentent simultanément une résistivité électrique et des conditions de gravure proches de celle de l'aluminium pur, et qui sont faciles à élaborer dans des conditions permettant de garantir des teneurs limitées en gaz dissous et en inclusions, de même qu'une grande homogénéité de composition.

### Description de l'invention

Le premier objet de l'invention est une cible de pulvérisation cathodique, destinée à la réalisation de circuits d'interconnexion de circuits électroniques, caractérisée en ce que sa partie active, c'est-à-dire le volume de la cible susceptible d'être enlevé lors des opérations de pulvérisation cathodique, est constituée d'un alliage d'aluminium de haute pureté contenant simultanément du cuivre et du fer, dont la température de recristallisation est nettement supérieure à la température ambiante, c'est-à-dire nettement supérieure à environ 20°C, tout en ayant une résistivité électrique inférieure à 3,0 µΩ.cm à 20°C.

Plus précisément, ledit alliage d'aluminium de haute pureté a une teneur totale en éléments autres que l'aluminium inférieure à 0,1 % en poids, et dont :
- les teneurs en éléments d'alliage, notamment en Cu et en Fe, sont telles que la température de recristallisation commençante de l'alliage est au moins égale à 150 °C. et de préférence encore au moins égale à 200 °C ;
- la teneur en Cu étant de préférence au moins égale à 5 ppm et au plus égale à 1000 ppm, et de préférence encore au moins égale à 15 ppm et au plus égale à 300 ppm ;
- la teneur en Fe étant de préférence au moins égale à 2 ppm et au plus égale à 60 ppm, et de préférence encore au moins égale à 3 ppm et au plus égale à 30 ppm ;
- les teneurs en éléments autres que l'aluminium, notamment en éléments d'alliage et en impuretés, étant telles que la résistivité électrique de l'alliage, mesurée sur échantillon massif complètement recristallisé, est inférieure à 2,85 µΩ.cm à 20°C, et dont les teneurs en Ti et B sont comme exposées dans la revendication 1.

La résistivité à l'état complètement recristallisé, également dite "à l'état recuit", est de préférence mesurée après un traitement thermique d'au moins 30 minutes à une température au moins égale à 400°C, cette température étant supérieure aux températures les plus élevées atteintes dans les procédés connus de fabrication de moniteurs à écran plat.

La température de recristallisation est définie soit par le début de la recristallisation. à l'aide de la température dite de recristallisation commençante Tc, soit par la fin de la recristallisation, à l'aide de la température dite de recristallisation finissante Tf. Dans la suite du texte, la température de recristallisation commençante Tc sera définie comme la température au-dessus de laquelle un échantillon ayant subi un écrouissage à froid correspondant à une réduction d'épaisseur par laminage de 83 % (correspondant à une déformation généralisée ε égale à 2) présente plus de 10% de grains recristallisés après un maintien de 15 minutes à cette température, et la température de recristallisation finissante Tf sera définie comme la température minimale qui conduit à la recristallisation de plus de 90 % des grains écrouis après un maintien de 15 minutes à cette température.

Au cours de ses recherches, la demanderesse a en effet constaté avec surprise que la propension des alliages d'aluminium de très haute pureté à former des protubérances à la surface des films déposés serait en fait liée à des phénomènes de recristallisation. La température de recristallisation des alliages ayant conduit à l'apparition de protubérances et de trous était généralement inférieure à environ 200°C, donc inférieure ou comparable aux températures habituelles de métallisation. Le mécanisme à la base de cette relation n'est cependant pas encore élucidé.

La composition, ainsi que l'état métallurgique, de l'alliage selon l'invention sont donc tels que la température de recristallisation commençante Tc dudit alliage est de préférence au moins égale à 150°C, et de préférence encore au moins égale à 200°C, de manière à réduire sensiblement le taux d'apparition et la taille des protubérances, tout en permettant de maintenir la résistivité électrique à des valeurs très faibles et très proches de celle de l'aluminium ultra-pur, c'est-à-dire nettement inférieures à 3,0 µΩ.cm à 20°C, de préférence inférieure ou égale à 2.85 µΩ.cm, mesurée à 20°C sur échantillon massif à l'état complètement recristallisé.

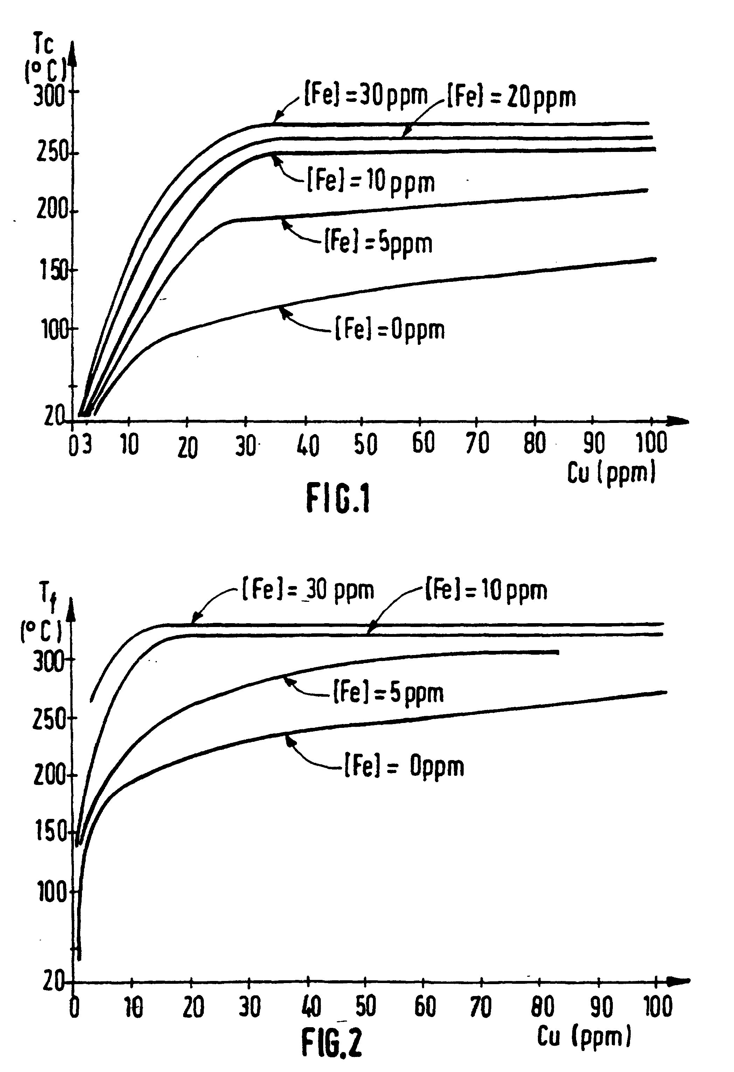

La demanderesse a aussi constaté que la présence simultanée de quantités modérées, mais supérieures à quelques ppm en poids chacun, de Fe et de Cu en tant qu'éléments d'alliage, permet de remonter très fortement la température de recristallisation de l'aluminium très pur (figures 1 et 2). Cet-effet d'interaction entre le fer et le cuivre est tout à fait surprenant, alors que chacun, agissant séparément, a des effets beaucoup plus faibles. Ces comportements n'obéissent pas à la théorie classique de la recristallisation et ne correspondent pas aux faits admis dans ce domaine, tel le fait que presque tous les éléments en solution solide devraient augmenter la température de recristallisation de manière substantielle même à des concentrations inférieures à 100 ppm (voir notamment "Aluminum - Properties and physical metallurgy", édité par J. E. Hatch, 1984, p. 120).

Les teneurs en éléments d'alliage et en impuretés de l'alliage selon l'invention sont aussi limitées par les risques de formation de précipités pouvant nuire à la qualité des gravures (notamment lorsque leur taille est supérieure à environ 15% de l'épaisseur du film) ou entraîner des difficultés de formation de ces gravures.

Des examens microscopiques par Microscopie électronique à transmission ont de plus montré que le nombre de précipités intermétalliques de Al₂Cu présent dans les films de métallisation obtenus avec l'alliage selon l'invention, et ensuite traités thermiquement à 400°C, était très faible pour des teneurs en Cu inférieures ou égales à 1000 ppm, ces précipités étant complètement absents pour des teneurs inférieures ou égales à 300 ppm.

La teneur en Fe est également limitée de façon à ce que la plupart du fer reste en solution solide dans l'aluminium et à ce que le nombre et la taille de certains précipités contenant du fer, tels que Al₃Fe et Al₆Fe, soient limités. Au-delà de 60 ppm de Fe, on constate une forte augmentation de la susceptibilité des interconnexions en alliage d'aluminium à la corrosion, par exemple lors des opérations de gravure par voie humide. Cet effet commence à être détectable au-delà de 30 ppm de Fe.

Selon une variante avantageuse de l'invention, pour les teneurs faibles en Fe et en Cu, l'alliage contient en outre du Si en tant qu'élément d'alliage. En particulier, lorsque la teneur en Cu est inférieure à 50 ppm et la teneur en Fe inférieure à 20 ppm, il est avantageux que la teneur en Si soit comprise entre 2 ppm et 30 ppm. Les teneurs en Cu, en Fe et en Si sont également telles que la température de recristallisation commençante soit supérieure à 150 °C, et de préférence supérieure à 200 °C, et la résistivité, à 20°C et à l'état recuit, est inférieure ou égale à 2,85 µΩ.cm.

La demanderesse a en effet noté que, pour des teneurs en Fe ou en Cu limitées aux valeurs précédentes, la présence de Si contribue, de manière modérée mais significative, à remonter les températures de recristallisation. A titre d'exemple, le tableau 1 montre l'influence d'une teneur modérée en silicium pour des teneurs eu cuivre et en fer respectivement limitées à 50 ppm et 20 ppm, la teneur totale en impuretés, c'est-à-dire en éléments autres que les éléments d'alliage Fe, Cu et Si, étant inférieure à 0,01 %. L'effet complémentaire du silicium, sensible aux faibles teneurs en fer et cuivre, s'estompe donc lorsque les teneurs en fer et eu cuivre atteignent respectivement 20 ppm et 50 ppm.

**Tableau 1**

| Teneurs (ppm en poids) | | | Tc(°C) | Tf(°C) |
|---|---|---|---|---|
| Fe | Cu | Si | | |
| 0 | 50 | 0 | 130 | 220 |
| 0 | 50 | 10 | 160 | 260 |
| 5 | 25 | 0 | 180 | 270 |
| 5 | 25 | 10 | 200 | 300 |
| 20 | 50 | 0 | 260 | 325 |
| 20 | 50 | - 10 | 260 | 325 |

De manière à assurer un affinage satisfaisant de la taille de grain des cibles de pulvérisation et ainsi à uniformiser la surface d'usure de la partie active de la cible, le procédé d'élaboration de l'alliage comprend un affinage qui consiste en une addition simultanée de Ti et de B en tant qu'éléments d'affinage, la teneur en titane dans l'alliage étant comprise entre 20 ppm et 80 ppm, la teneur en bore étant supérieure à 4 ppm, et la teneur en B étant telle que le rapport pondéral Ti/B soit compris entre 2,5 et 10.

Selon une autre variante de l'invention, l'alliage contient des éléments d'alliage complémentaires, tels que des terres rares, dans des teneurs supérieures à 5 ppm et inférieures à 0,05 %, qui permettent d'améliorer notamment les propriétés d'interface et d'adhérence entre le circuit d'interconnexion en alliage selon l'invention et d'autres couches juxtaposées, la tenue à la corrosion des interconnexions, et le pouvoir diélectrique de la couche d'oxyde d'aluminium éventuellement formée à la surface des interconnexions.

La teneur totale en impuretés, c'est-à-dire en éléments autres que les éléments d'alliage et d'affinage, est de préférence inférieure à 0,01 %, de manière à éviter tout risque de formation de précipités intermétalliques de taille supérieure à 10 µm et, pour les éléments qui sont très solubles dans l'aluminium solide, de manière à réduire la résistivité de l'alliage.

De préférence, la teneur totale en impuretés alcalines (Li, Na, K, Rb. Cs) de l'alliage selon l'invention est inférieure à 0,0005 %. La teneur en impuretés alcalines est limitée par les effets extrêmement néfastes qu'elles peuvent avoir du fait de leur très grande vitesse de migration, notamment le long des lignes d'interconnexion, vers les interfaces avec d'autres matériaux.

L'alliage selon l'invention peut être obtenu par addition des éléments d'alliage et, éventuellement, d'affinage sélectionnés à une matrice d'aluminium de très haute pureté, de préférence supérieure à 4N (c'est-à-dire plus de 99,99% d'aluminium), et de préférence encore supérieure à 4N7 (c'est-à-dire plus de 99,997% d'aluminium).

La partie active de la cible selon l'invention est avantageusement obtenue par laminage de tôles en alliage selon l'invention. De manière à obtenir une grande isotropie du métal, c'est-à-dire de manière à éliminer la texture, ce qui favorise une vitesse d'usure uniforme sur la surface de la cible, les conditions de laminage sont telles que la recristallisation s'effectue durant le laminage, c'est-à-dire plus précisément lors du passage de la tôle entre les rouleaux de laminage, ou peu après ce passage. Cette recristallisation en cours de laminage est de préférence obtenue en effectuant le laminage à une température supérieure à Tf + 50°C, où Tf est la température de recristallisation finissante de l'alliage. Le laminage est de préférence effectué de manière croisée, chaque passe de laminage conduisant à une réduction d'épaisseur d'au moins 20 %. En outre, il est préférable que le temps d'attente entre chaque passe permette la recristallisation d'au moins 50 % de la tôle.

De préférence, la partie active de la cible selon l'invention ne présente aucune décohésion interne de taille supérieure à 0,7 mm et comporte moins de 10 décohésions internes de taille supérieure à 200 µm par décimètre cubé de métal actif, c'est-à-dire de métal susceptible d'être enlevé lors de l'opération de pulvérisation cathodique. Ces limites permettent de maintenir à un niveau entièrement satisfaisant la fréquence d'apparition des défauts de gravure causés par la redéposition de panicules et de gouttelettes arrachées à la cible durant l'opération de métallisation par pulvérisation cathodique.

La santé interne de la partie active de la cible, c'est-à-dire le nombre et la taille des décohésions internes, est avantageusement évaluée par un contrôle par ultrasons, de préférence à une fréquence supérieure ou égale à 8 MHz, selon un procédé connu par la demande française n° 96 01990 au nom de la demanderesse.

De préférence encore, le métal actif présente des tailles de grain inférieures à 2 mm de manière à ce que l'homogénéité du film déposé soit satisfaisante, tant en composition qu'en épaisseur, et de façon à obtenir une usure très uniforme de la partie active de la cible.

L'invention a aussi pour objet un circuit d'interconnexion électrique caractérisé en ce qu'il comporte au moins une couche d'interconnexion en alliage d'aluminium selon l'invention, ladite couche étant de préférence obtenue par pulvérisation cathodique à partir d'une cible selon l'invention, et présentant de ce fait une résistance à la recristallisation très améliorée par rapport à celle de l'aluminium non allié, tout en conservant une excellente aptitude à la gravure et une faible résistivité, proches de celles de l'aluminium pur.

### FIGURES

La figure 1 montre l'influence des teneurs en Cu et en Fe des alliages d'aluminium selon l'invention sur la température de recristallisation commençante Tc. La teneur totale en éléments autres que le Cu et le Fe est inférieure ou égale à 0,01 %.

La figure 2 montre l'influence des teneurs en Cu et en Fe des alliages d'aluminium selon l'invention sur la température de recristallisation finissante Tf. La teneur totale en éléments autres que le Cu et le Fe est inférieure ou égale à 0,01 %.

### EXEMPLES

### Exemple 1

Ou a élaboré, dans un four à chauffage électrique, environ 4.6 tonnes d'un alliage d'aluminium en partant d'aluminium raffiné de pureté égale à 99,998 % auquel on a ajouté de faibles quantités de Fe et de Cu de manière à obtenir une teneur en Fe de 8 ppm et une teneur en Cu de 40 ppm. L'alliage obtenu contenait également 9 ppm de Si.

L'alliage obtenu a ensuite été coulé sous forme de plaque de laminage de section 500 mm x 1 055 mm, et d'une longueur de 3 200 mm. Pendant la coulée, l'alliage a été traité au défilé dans 2 poches successives de façon à en réduire les teneurs en hydrogène dissous et en inclusions. La première poche était une poche de dégazage munie d'un rotor d'injection d'argon, selon le procédé ALPUR ® développé par la demanderesse. La seconde poche était une poche de filtration à lit profond de graviers d'alumine tabulaire, également selon un procédé développé par la demanderesse et connu sous le nom de PECHINEY DBF (Deep Bed Filter).

La plaque a ensuite été sciée de façon à en éliminer les zones perturbées de pied et de tête de plaque, et sa longueur a été ramenée à 2 400 mm.

Des tranches ont aussi été prélevées, perpendiculairement à l'axe de coulée, en tête et en pied de plaque, en vue de contrôler la structure macrographique et la teneur en gaz du métal soldifié. Ces examens ont révélé une structure macrographique très grossière (c'est-à-dire des grains de section centimétrique et allongés perpendiculairement au front de solidification), une légère porosité de retrait au coeur du produit et une teneur en hydrogène inférieure à 0,07 ppm.

Les grandes faces de cette plaque ainsi sciée ont ensuite été scalpées par fraisage, d'environ 8 mm par face, de manière à en éliminer la peau de coulée et la zone corticale à grains basaltiques fins. La plaque ainsi scalpée a ensuite été homogénéisée pendant 32 heures à 580 °C, dans un four électrique à atmosphère sèche de manière à homogénéiser sa composition à l'échelle microscopique tout eu évitant de la regazer. Cette plaque a ensuite été refroidie dans le four, mis à l'air ambiant, jusqu'à 500°C. puis placée sur la table d'alimentation d'un laminoir réversible et laminée parallèlement à l'axe de coulée, en plusieurs passes, jusqu'à ce que son épaisseur soit réduite à 75 mm. En sonie de cette première étape de laminage, la température de la bande était de 460°C environ.

La bande issue de l'opération de laminage, d'une longueur d'environ 15,50 m, a ensuite été débitée par cisaillage en morceaux de 1 m de longueur, après élimination d'une bande de 25 cm en tête et en pied de bande.

Après une rotation de 90° autour d'un axe perpendiculaire aux grandes faces de chaque morceau, chacun de ces morceaux a été immédiatement relaminé à chaud en plusieurs passes, selon une direction perpendiculaire à la direction de laminage précédente (laminage dit "croisé"), jusqu'à réduire son épaisseur à 12,5 mm. En sortie de cette deuxième étape de laminage, la température des bandes était comprise entre 370°C et 410°C, en fonction de l'ordre de passage au laminage.

On a ainsi obtenu 15 bandes de 12,5 mm d'épaisseur, de 1 000 mm de largeur et de 6,3 m de longueur, que l'on a redécoupées par cisaillage de façon à obtenir 90 tôles de 12,5 mm d'épaisseur, de 1 000 mm de largeur et de 900 mm de longueur, aptes à être usinées en cibles de pulvérisation cathodique.

Des mesures des températures de la recristallisation ont été effectuées sur l'aluminium raffiné initial et sur l'alliage obtenu après addition de Cu et de Fe. Ces mesures ont permis de constater que l'alliage raffiné initial avait des températures de recristallisation commençante et finissante inférieures à 25 °C, d'une part, et que l'alliage obtenu avait des températures de recristallisation commençante et finissante respectivement égales à 250 °C et à 320 °C, d'autre part.

On a également procédé à un contrôle micrographique sur des échantillons de tôles, qui a révélé que les tôles obtenues avaient une taille de grain homogène et fine, inférieure à 2 mm parallèlement aux grandes faces, et aplatie parallèlement à celles-ci, d'une épaisseur inférieure à 0,7 mm. A titre de comparaison, des bandes laminées uniquement parallèlement à l'axe de coulée présentaient un grain allongé dans le sens du laminage, atteignant jusqu'à 3 mm, et également un résidu de texture de laminage, c'est-à-dire une orientation préférentielle dans le sens du laminage.

Des examens micrographiques complémentaires ont révélé l'absence de précipités intermétalliques.

La résistivité du métal, mesurée à 20 °C, sur des échantillons recristallisés prélevés sur les tôles, n'excédait pas 2,70 µΩ.cm.

Après ces opérations de laminage et de découpe, puis de refroidissement, chaque tôle a été contrôlée par inspection ultrasonore en immersion, à une fréquence de 10 MHz, et les échos ultrasonores enregistrés ont été comparés à celui d'un fond plat de 300 µm de diamètre. Ces mesures ont permis de classer les tôles en 3 catégories, selon le nombre d'échos de taille équivalente supérieure à 200 µm par décimètre cube de métal inspecté: celles présentant plus de 10 échos (8 tôles), celles présentant de 2 à 10 échos (27 tôles) et celles présentant moins de 2 échos (55 tôles).

Suite à ces contrôles, une tôle de chacune des trois catégories a été prélevée, usinée en surface à l'aide d'un outil diamaut afin de réduire son épaisseur à 10 mm, puis usinée sur les côtés de manière à obtenir des plaques finales de dimensions 790 mm x 880 mm x 10 mm. Ces plaques ont été raccordées à des supports de connexion électrique et de refroidissement, selon la technique connue de réalisation des cibles de pulvérisation cathodique.

Ces trois cibles out été utilisées pour la métallisation de substrats de verre de dimensions 550 x 650 mm aptes à la production d'écrans plats selon la technique habituellement utilisée pour la fabrication d'interconnexions à base d'aluminium de très haute pureté (5N). La température du substrat pendant le dépôt était de 200°C, c'est-à-dire inférieure à Tc, et la passivation a été réalisée à 320°C, c'est-à-dire à une température proche de Tc.

Les contrôles de fabrication, à l'aide d'examens par microscopie optique, ont alors montré, pour les trois cibles mises à l'essai, que la fréquence d'apparition des protubérances était environ plus de deux fois inférieure à celle observée pour des moniteurs métallisés à l'aide de cibles en aluminium de très haute pureté contenant moins de 2 ppm chacun de Fe et de Cu, et que surtout la hauteur de ces protubérances avait été fortement diminuée, la hauteur maximum passant de 0,5 µm à 0,2 µm. En outre, la taille des grains des films d'alliage d'aluminium selon l'invention était sensiblement plus faible, soit un facteur 3 environ, que celle observée avec l'aluminium 5N non dopé.

Des protubérances de hauteur inférieure à 0,2 µm sont considérées comme tout à fait acceptables pour la suite des opérations de fabrication des écrans, alors qu'au contraire des protubérances dépassant 0,3 µm de hauteur, ou même 0.4 µm, sont souvent rédhibitoires, car elles dépassent l'épaisseur des films déposés ou formés ultérieurement à la surface des interconnexions en alliages d'aluminium ou en aluminium pur.

Cependant, les moniteurs fabriqués à partir de la cible appartenant à la première catégorie (c'est-à-dire contenant plus de 10 défauts de taille supérieure à 200 µm par décimètre cube de métal actif) présentaient un nombre de défauts de gravure significativemeut supérieur à celui des moniteurs fabriqués à partir des deux autres cibles, ce qui a entraîné le rebut de plus de 10 % des moniteurs fabriqués. Ces défauts de gravure ont été reliés à la redéposition, sur le film d'aluminium, de gouttelettes liquides arrachées à la cible par l'apparition de micro-arcs en cours d'opération de métallisation.

### Exemple 2

Des essais ont aussi été réalisés dans les mêmes conditions que l'exemple 1, à l'exception de la procédure d'élaboration de l'alliage d'aluminium au moment de la coulée.

Au moment de la coulée, une addition de B et de Ti a été réalisée au défilé dans le métal liquide à l'aide d'un fil d'alliage d'aluminium de haute pureté contenant 5% Ti et 1% B en poids. La vitesse d'introduction du fil a été réglée de façon à obtenir une teneur en Ti de l'ordre de 50 ppm et une teneur en B de l'ordre de 10 ppm dans l'alliage coulé, c'est-à-dire que l'on a introduit 1 kg de fil d'alliage par tonne de métal coulée.

Les tranches macrographiques prélevées lors du sciage des extrémités de la plaque brute ont alors révélé une structure granulaire du métal beaucoup plus fine que dans l'exemple précédent, et une forte diminution des porosités de retrait à coeur de plaque.

Après laminage, dans des conditions identiques à celles de l'exemple 1, le grain des tôles était également plus fin et ses dimensions ne dépassaient pas 1 mm dans toutes les directions. La résistivité mesurée sur des échantillons de tôle n'excédait pas 2,80 µΩ.cm à 20°C. De surcroît, lors des contrôles aux ultrasons, seules 2 tôles sur les 90 tôles fabriquées ont présenté plus de 10 échos de taille équivalente supérieure à 200 µm par décimètre cube de métal.

Les cibles fabriquées à partir de cet alliage, selon une procédure identique à celle de l'exemple 1, et mises à l'essai dans des conditions également identiques ont conduit à des résultats légèrement améliorés en ce qui concerne la fréquence d'apparition des protubérances et leur taille, et l'on a constaté parallèlement que la taille du grain des films, après le traitement de passivation à 400°C, était également plus petite.

Ces essais ont montré que l'affinage par addition simultanée et modérée de B et de Ti permet d'augmenter sensiblement la proportion de tôles satisfaisantes en ce qui concerne le nombre et la taille des décohésions internes, tout en préservant les caractéristiques visés dans la présente invention, et même en les améliorant légèrement.

### AVANTAGES

Les essais effectués par la demanderesse ont donc montré que, de manière inattendue et contraire à l'enseignement connu, il était est possible de concevoir des nuances d'alliages d'aluminium de faibles teneurs en certains éléments qui permettent de limiter sensiblement l'apparition de protubérances et de trous en surface des films obtenus par pulvérisation cathodique à partir de ces alliages, tout en présentant des caractéristiques d'usage proches des aluminium de très haute pureté, notamment une très faible résistivité électrique et une grande aptitude à la gravure.

La présence simultanée de quantités modérées, mais supérieures à quelques ppm en poids chacun, de Fe et de Cu permet de réduire sensiblement le taux d'apparition et la taille des protubérances, en relation avec une forte augmentation de la température de recristallisation par rapport à l'aluminium très pur, tout en permettant de maintenir la résistivité électrique à des valeurs très faibles et très proches de celle de l'aluminium ultra-pur, c'est-à-dire nettement inférieures à 3,0 µΩ.cm à 20°C.

La cible selon l'invention est utilisable dans les procédés connus de métallisation par pulvérisation cathodique sans modification de la technique et de permettre une gravure dans les mêmes conditions que celles utilisées pour les aluminiums de très haute pureté.

Les circuits d'interconnexion selon l'invention présentent, outre une résistance élevée à la formation de protubérances, une résistance électrique comparable aux résistances obtenues avec de l'aluminium de très haute pureté non allié, de posséder des grains d'une grande finesse et d'offrir une tenue en température de cette finesse plus grande que celle de l'aluminium ultra-pur (plus de 5N) gràce à la valeur élevée de la température de recristallisation.

## Revendications

1. Cible de pulvérisation cathodique dont la partie active, c'est-à-dire le volume de ladite cible susceptible d'être enlevé lors des opérations de pulvérisation cathodique, est constituée d'un alliage d'aluminium de haute pureté, dont la teneur totale en éléments autres que l'aluminium est inférieure à 0,1 % en poids et dont :
- les teneurs en éléments d'alliage, notamment en Cu et en Fe, sont telles que la température de recristallisation commençante dudit alliage est au moins égale à 150°C ;
- la teneur en Cu étant au moins égale à 5 ppm et au plus égale à 1000 ppm ;
- la teneur en Fe étant au moins égale à 2 ppm et au plus égale à 60 ppm ;
- les teneurs en éléments autres que l'aluminium, notamment en éléments d'alliage et en impuretés, étant telles que la résistivité électrique dudit alliage, mesurée sur échantillon massif complètement recristallisé, est inférieure à 2,85 µΩ.cm à 20°C,
et ledit alliage comprend aussi du Ti et du B, la teneur en Ti étant comprise entre 20 ppm et 80 ppm, la teneur en B étant supérieure à 4 ppm, et le rapport pondéral titane sur bore (Ti/B) étant compris entre 2,5 et 10.

2. Cible selon la revendication 1, **caractérisée en ce que** les teneurs en éléments d'alliage sont telles que la température de recristallisation commençante dudit alliage est au moins égale à 200°C.

3. Cible selon l'une des revendications 1 et 2, **caractérisée en ce que** la teneur en Cu dudit alliage est au moins égale à 15 ppm et au plus égale à 300 ppm, et **en ce que** la teneur en Fe dudit alliage est au moins égale à 3 ppm et au plus égale à 30 ppm.

4. Cible selon l'une des revendications 1 à 3, **caractérisée en ce que** la teneur en Cu dudit alliage est inférieure à 50 ppm, **en ce que** la teneur en Fe dudit alliage est inférieure à 20 ppm, et **en ce que** la teneur en Si dudit alliage est comprise entre 2 ppm et 30 ppm.

5. Cible selon l'une des revendications 1 à 4, **caractérisée en que** la teneur totale en impuretés dudit alliage est inférieure à 0,01 %.

6. Cible selon l'une des revendications 1 à 5, **caractérisée en ce que** la teneur totale en impuretés alcalines (Li, Na, K, Rb, Cs) dudit alliage est inférieure à 0,0005 %.

7. Cible selon l'une des revendications 1 à 6, **caractérisée en ce que** la partie active de ladite cible ne présente aucune décohésion interne de taille supérieure à 0,7 mm et comporte moins de 10 décohésions internes de taille supérieure à 200 µm par décimètre cube de métal actif, c'est-à-dire de métal susceptible d'être enlevé lors de l'opération de pulvérisation cathodique.

8. Cible selon la revendication 7, **caractérisée en ce que** le métal actif présente des tailles de grain inférieures à 2 mm.

## Claims

1. Cathode sputtering target wherein the active part, i.e. the volume of said target liable to be removed during cathode sputtering operations, consists of a high purity aluminium alloy, wherein the total content of elements other than aluminium is less than 0.1% by weight and wherein:
- the contents of alloy elements, particularly Cu and Fe, are such that the initiating recrystallization temperature of said alloy is at least equal to 150°C;
- the Cu content being at least equal to 5 ppm and at most equal to 1000 ppm;
- the Fe content being at least equal to 2 ppm and at most equal to 60 ppm;
- the contents of elements other than aluminium, particularly alloy elements and impurities, being such that the electrical resistivity of said alloy, measured on a completely recrystallized solid sample, is less than 2.85 µΩ.cm at 20°C,
and said alloy also comprises Ti and B, the Ti content being between 20 ppm and 80 ppm, the B content being greater than 4 ppm, and the titanium-to-boron ratio by weight (Ti/B) being between 2.5 and 10.

2. Target according to claim 1, **characterized in that** the alloy element contents are such that the initiating recrystallization temperature of said alloy is at least equal to 200°C.

3. Target according to any of claims 1 and 2, **characterized in that** the Cu content of said alloy is at least equal to 15 ppm and at most equal to 300 ppm, and **in that** the Fe content of said alloy is at least equal to 3 ppm and at most equal to 30 ppm.

4. Target according to any of claims 1 to 3, **characterized in that** the Cu content of said alloy is less than 50 ppm, **in that** the Fe content of said alloy is less than 20 ppm, and **in that** the Si content of said alloy is between 2 ppm and 30 ppm.

5. Target according to any of claims 1 to 4, **characterized in that** the total impurity content of said alloy is less than 0.01%.

6. Target according to any of claims 1 to 5, **characterized in that** the total content of alkaline impurities (Li, Na, K, Rb, Cs) of said alloy is less than 0.0005%.

7. Target according to any of claims 1 to 6, **characterized in that** the active part of said target does not comprise any internal decohesion greater than 0.7 mm in size and comprises less than 10 internal decohesions greater than 200 µm in size per cubic decimetre of active metal, i.e. metal liable to be removed during the cathode sputtering operation.

8. Target according to claim 7, **characterized in that** the active metal has grain sizes less than 2 mm.

## Patentansprüche

1. Target für Kathodenzerstäubung, dessen aktiver Teil, d.h. das bei den Kathodenzerstäubungen abtragbare Volumen des Targets, aus einer hochreinen Aluminiumlegierung besteht, deren Gesamtgehalt an anderen Elementen als Aluminium weniger als 0,1 Gew.-% beträgt und:
- deren Gehalte an Legierungselementen, insbesondere an Cu und Fe, so sind, dass die Temperatur der Legierung, bei der die Rekristallisation beginnt, mindestens 150 °C beträgt;
- wobei der Gehalt en Cu mindestens 5 ppm und höchstens 1000 ppm beträgt;
- der Gehalt en Fe mindestens 2 ppm und höchstens 60 ppm beträgt;
- die Gehalte an anderen Elementen als Aluminium, insbesondere an Legierungselementen und Verunreinigungen, so sind, dass der spezifische elektrische Widerstand der Legierung, gemessen an vollständig rekristallisierten, massiven Proben, kleiner als 2,85 µΩ.cm bei 20 °C ist,
- und die Legierung zusätzlich Ti und B enthält, wobei der Gehalt an Ti 20 ppm bis 80 ppm beträgt, der Gehalt an B mehr als 4 ppm beträgt und das Gewichtsverhältnis Titan zu Bor (Ti/B) 2,5 bis 10 beträgt.

2. Target nach Anspruch 1, **dadurch gekennzeichnet, dass** die Gehalte an Legierungselementen so sind, dass die Temperatur der Legierung, bei der die Rekristallisation beginnt, mindestens 200 °C beträgt.

3. Target nach einem der Ansprüche 1 und 2, **dadurch gekennzeichnet, dass** der Cu-Gehalt der Legierung mindestens 15 ppm und höchstens 300 ppm beträgt und dass der Fe-Gehalt der Legierung mindestens 3 ppm und höchstens 30 ppm beträgt.

4. Target nach einem der Ansprüche 1 bis 3, **dadurch gekennzeichnet, dass** der Cu-Gehalt der Legierung weniger als 50 ppm beträgt, dass der Fe-Gehalt der Legierung weniger als 20 ppm beträgt und dass der Si-Gehalt der Legierung 2 bis 30 ppm beträgt.

5. Target nach einem der Ansprüche 1 bis 4, **dadurch gekennzeichnet, dass** der Gesamtgehalt der Legierung an Verunreinigungen weniger als 0,01 % beträgt.

6. Target nach einem der Ansprüche 1 bis 5, **dadurch gekennzeichnet, dass** der Gesamtgehalt der Legierung an alkalischen Verunreinigungen (Li, Na, K, Rb, Cs) weniger als 0,0005 % beträgt.

7. Target nach einem der Ansprüche 1 bis 6, **dadurch gekennzeichnet, dass** der aktive Teil des Targets keine interne Dekohäsion von mehr als 0,7 mm Größe aufweist und weniger als 10 interne Dekohäsionen von mehr als 200 µm Größe pro Kubikdezimeter Aktivmetall, d.h. beim Kathodenzerstäuben abtragbares Metall enthält.

8. Target nach Anspruch 7, **dadurch gekennzeichnet, dass** das Aktivmetall Korngrößen kleiner als 2 mm aufweist.
